# EUROPEAN PATENT APPLICATION

(11) **EP 3 968 373 A1**
(43) Date of publication of application: **16.03.2022**
(21) Application number: 20195344.5
(22) Date of filing: 09.09.2020
(51) Int. Cl.: H01L 25/075, H01L 33/62

(54) **LOW Z-HEIGHT LED ARRAY PACKAGE HAVING TSV SUPPORT STRUCTURE**

(71) Applicant: Lumileds LLC, San Jose, CA 95131 (US)
(72) Inventor: The designation of the inventor has not yet been filed
(74) Representative: dompatent von Kreisler Selting Werner - Partnerschaft von Patent- und Rechtsanwälten mbB

(57) **Abstract**

A packaging structure for a light emitter pixel array includes a plurality of pixels, with at least some pixels laterally separated from each other with a pixel light confinement structure. An inorganic substrate having a top redistribution layer is attached to the plurality of pixels and at least one through silicon via containing an electrical conductor is defined to pass through the inorganic substrate and support an electrical connection with the top redistribution layer.

## Description

### TECHNICAL FIELD

The present disclosure generally relates to manufacture of high density substrates for densely packed light emitting diodes or lasers. An electrical interconnect system including through silicon vias (TSV) and supporting address of LED pixel arrays is described.

### BACKGROUND AND SUMMARY

Semiconductor light-emitting devices (LEDs) can be arranged or formed in densely packed groups or blocks. However, when a light-emitting is small, or many light-emitting devices are grouped together, providing reliable interconnections is difficult, particularly if each light-emitting device must be separately addressable and also provide adequate heat removal.

One solution for mounting LEDs with large numbers of addressable pixels can require provision of small electrical traces, extensive fan-in or fan-out structures, or vias. This can be accomplished, for example, by mounting individual LEDs or LED modules on a solid ceramic, glass, or silicon substrate. Unfortunately, such mounting systems can require use of expensive materials, provision for numerous microvias, and complex processing equipment. Further, in many cases ceramic mounting systems are poorly coefficient of thermal expansion (CTE) matched to organic circuit board material, resulting in early failure of trace interconnects due to thermal expansion and contraction cycles that result in traces breaking at the boundary between ceramic and organic materials.

In accordance with embodiments of the invention, a packaging structure for a light emitter pixel array includes a plurality of pixels, with at least some pixels laterally separated from each other with a pixel light confinement structure. An inorganic substrate having a top redistribution layer is attached to the plurality of pixels and at least one through silicon via containing an electrical conductor is defined to pass through the inorganic substrate and support an electrical connection with the top redistribution layer.

In some embodiments, a top redistribution layer is attached to each pixel using a copper post.

In some embodiments, the inorganic substrate further includes a bottom redistribution layer attached to the least one through silicon via containing an electrical conductor.

In some embodiments, the light confinement structure further includes phosphor material at least partially surrounded by a reflective side coating.

In some embodiments, the light confinement structure further includes a diffusing layer aligned with phosphor material

In some embodiments, total Z-height of the packaging structure is less than 300 microns.

In some embodiments, the plurality of pixels includes at least nine pixels.

In some embodiments, the plurality of pixels are formed from a segmented GaN layer.

In some embodiments, the plurality of pixels are formed from a segmented GaN layer with pixels separated by infilled trenches.

In some embodiments, a CMOS die is attached to the bottom redistribution layer of the inorganic substrate.

In some embodiments, an underfill is provided between a segmented GaN layer and the inorganic substrate.

In some embodiments, circuitry is formed on the inorganic substrate.

In some embodiments, at least one sensor is attached to the inorganic substrate.

In some embodiments, at least one sensor temperature sensor is attached to the inorganic substrate.

### BRIEF DESCRIPTION OF THE DRAWINGS

Non-limiting and non-exhaustive embodiments of the present disclosure are described with reference to the following figures, wherein like reference numerals refer to like parts throughout the various figures unless otherwise specified.
FIG. 1 illustrates one embodiment in cross section of a LED with a high-density substrate including through silicon vias; and
FIG. 2 illustrates multiple LEDs assembled on a strip; and
FIG. 3A and 3B illustrate respectively back connections and internal connections for a through silicon via substrate.

### DETAILED DESCRIPTION

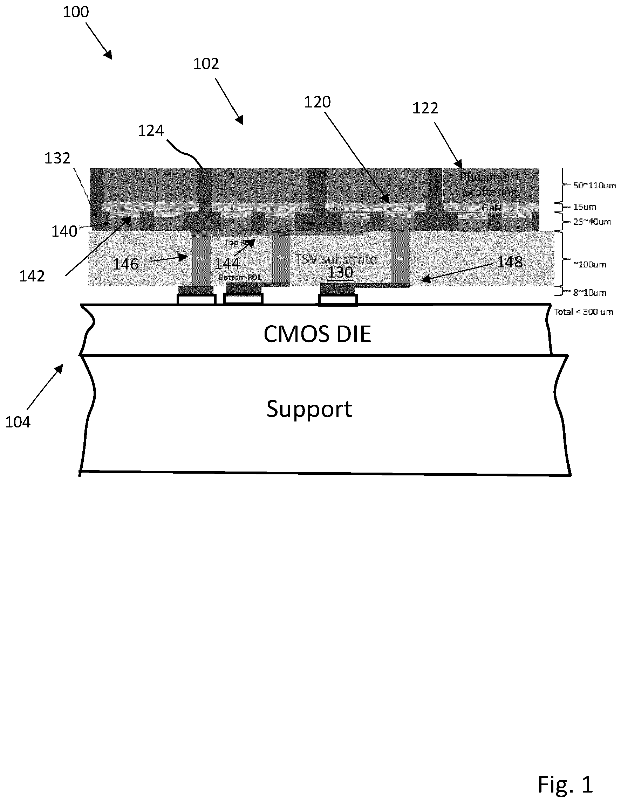

As seen in FIG. 1, a packaging structure for a light emitter pixel array 100, shown in cross section, includes a multiple pixel assembly 102 that can be optionally mounted on a CMOS die and support 104. In one embodiment, the pixel assembly 102 includes GaN or other suitable active light emitter 120 topped with a phosphor and diffuser layer 122. Individual pixels are separated by a pixel light confinement structure 124. The active light emitter 120 and phosphor/diffuser 122 can be supported and electrically connected using a silicon substrate 130 having through silicon vias (TSV) filled with electrically conductive material. In one embodiment, copper or other metallic posts 140 can be attached to the light emitter 120 with a solder material 142. The copper pillar can 140 can be protected and the light emitter 120 attached to the silicon substrate 130 with the aid of an electrically non-conductive and adhesive underfill 132. The copper pillars can be attached to an electrically conductive top redistribution layer 144 formed or applied to a top surface of the silicon substrate 130. The top redistribution layer 144 is electrically connected to electrically conductive material in through silicon vias (TSV) 146. The TSV 146 is in turn connected to an electrically conductive bottom redistribution layer 148 formed or applied to a bottom surface of the silicon substrate 130. Advantageously, this dense electrical connection scheme allows pixels or groups or pixels to be separately addressed and controlled for light intensity. In some embodiments, thickness (Z-height) of the multiple pixel assembly 102 is selected to be less than 500 microns. In other embodiments, thickness of the multiple pixel assembly 102 is selected to be less than 300 microns. In other embodiments, thickness is between 250 and 300 microns. In other embodiments, thickness of the multiple pixel assembly 102 is selected to be less than 250 microns. In other embodiments, thickness is between 100 and 300 microns.

There are various advantages to the described structure and system. Use of a silicon substrate for light emitting elements provides dense interconnect for adaptive lighting systems, while also providing good thermal transfer characteristics as compared to organic substrates. Also, low Z-height packaging is needed for thin, non-bulky lighting modules. In particular, having a height similar to simple LED flash lighting systems allows for easy redesign and replacement of conventional non-pixel camera flash with addressable adaptive flash.

The multiple pixel assembly 102 can include light emitting elements of various types, sizes, and layouts. In one embodiment, one or two dimensional matrix arrays of individually addressable light emitting diodes (LEDs) can be used. Commonly NxM arrays where N and M are respectively between two and one thousand can be used. Individual LED structures can have a square, rectangular, hexagonal, polygonal, circular, arcuate or other surface shape. Arrays of the LED assemblies or structures can be arranged in geometrically straight rows and columns, staggered rows or columns, curving lines, or semi-random or random layouts. LED assemblies can include multiple LEDs formed as individually addressable pixel arrays are also supported. In some embodiments, radial or other non-rectangular grid arrangements of conductive lines to the LED can be used. In other embodiments, curving, winding, serpentine, and/or other suitable non-linear arrangements of electrically conductive lines to the LEDs can be used.

To provide a range of colors, various phosphors and associated diffusers 122 can be used. Diffusers can include films, coatings, or dispersed titanium oxide in a polymeric binder or other suitable material. In addition to diffusers, LED structures can be overlain with wavelength converting materials such as molded or ceramic phosphor or other materials such as quantum dots or dyes. Multiple types and thicknesses of phosphors can be used. An LED combined with one or more wavelength converting materials may be used to create white light or monochromatic light of other colors. All or only a portion of the light emitted by the LED may be converted by the wavelength converting material. Unconverted light may be part of the final spectrum of light, though it need not be. Examples of common devices include a blue-emitting LED combined with a yellow-emitting phosphor, a blue-emitting LED combined with green- and red-emitting phosphors, a UV-emitting LED combined with blue- and yellow-emitting phosphors, and a UV-emitting LED combined with blue-, green-, and red-emitting phosphors. The phosphors can be electrophoretically deposited on an LED with application of a voltage. Varying applied voltage duration will correspondingly vary amount and thickness of deposited phosphors. Alternatively, the LED can be coated with the phosphor, using an organic binder to adhere the phosphor particles to the LED. Phosphors and/or diffuser material can be dispensed, screen printed, sprayed, molded, applied as films, or laminated. Alternatively, for certain applications, a phosphor contained in glass, or a pre-formed sintered ceramic phosphor can be attached to the LED. In some embodiments, thickness (Z-height) of phosphors and associated diffusers 122 is selected to be less than 200 microns. In other embodiments, thickness of phosphors and associated diffusers 122 is selected to be between 50 and 110 microns.

In some embodiments, the pixel light confinement structure 124 can be formed from a light reflective or light absorptive sidewall coating. This can include or have additional light absorbers, reflectors (including stack of dielectric layers that form a distributed Bragg reflector for a sidewall), other optical coating, or electrically insulative material. Optically and electrically isolating dielectric material that can include organic, inorganic, or organic/inorganic binder and filler material can be used. For example, adhesives, epoxies, acrylate or nitrocellulose can be used in conjunction with ceramic or light absorptive or scattering particles. Another organic/inorganic binder, filler, or sidewall can be, for example, epoxy with embedded reflective titanium oxide or other reflective/scattering particles. Inorganic binders can include sol-gel (e.g., a sol-gel of TEOS or MTMS) or liquid glass (e.g., sodium silicate or potassium silicate), also known as water glass. In some embodiments binders can include fillers that adjust physical properties. Fillers can include inorganic nanoparticles, silica, glass particles or fibers, or other materials able to improve optical or thermal performance. In some embodiments, pixel light confinement structure 124 is arranged so that distance between pixels is selected to be less than 30 microns. In other embodiments, distance between pixels is selected to be between 30 and 5 microns.

In some embodiments, the active light emitter 120 can be formed from semiconductor materials capable of forming high-brightness light emitting devices can include, but are not limited to, Group III-V semiconductors, particularly binary, ternary, and quaternary alloys of gallium, aluminum, indium, and nitrogen, also referred to as III-nitride materials. Such semiconductor materials can be grown to support both LED and laser systems as necessary. In some embodiments, a sapphire substrate that can be thinned or otherwise removed in whole or in part can be used. In some embodiments, the LED die can be further thinned. In one embodiment, GaN grown on a sapphire substrate removed by laser lift-off techniques is used. In some embodiments, GaN can be wholly or partially separated (e.g. partially cut through to define a trench) into pixels or groups of pixels. In some embodiments, thickness (Z-height) of the active light emitter 120 is selected to be less than 15 microns. In other embodiments, thickness of the active light emitter 120 is selected to be between 15 and 7 microns.

In one embodiment, copper or other metallic posts 140 can be attached to the light emitter 120 with a solder material 142. In other embodiments, bump on trace, ACF, or Cu to Cu direct bonding can be used. In some embodiments, combined thickness (Z-height) of the metallic posts 140 and solder or other electrical connector is selected to be less than 60 microns. In other embodiments, combined thickness of the metallic posts 140 and solder or other electrical connector is selected to be between 10 and 60 microns.

In some embodiments, the silicon substrate 130 can include other organic or inorganic substrate material. Silicon substrates can be embedded or emplaced in surrounding inorganic or organic substrates, including but not limited to conventional printed circuit board substrates. In some embodiments, the silicon substrate can be replaced with a glass, ceramic, or other inorganic material. In some embodiments, thickness (Z-height) of the substrate 130 is selected to be less than 100 microns. In other embodiments, thickness of the substrate 130 is selected to be between 40 and 100 microns.

The substrate 130 can support various electrically conductive structures on a top, bottom, side, or interior of the substrate 130, including electrically conductive top redistribution layer 144 and bottom redistribution layer 148. Interior electrically conductive structures can be formed from electrically conductive vias defined in either an organic or an inorganic substrate. These conductive vias can be electrically connected top and bottom redistribution layers that horizontally extend electrical traces to connect to the conductive vias. In some embodiments, conductive vias can be replaced with microvias, wires, metal pillars, solder columns, or other suitable structures. As will be understood, various arrangements of electrical traces forming redistribution layers can be utilized, including fan-in, fan-out, linear, or curved horizontal layouts. Electrically conductive structures or traces can be formed from a variety of electrically conductive metals such as copper, silver, aluminum, gold, metal alloys or conductive polymeric compositions, graphene, or conductive ceramics. In some embodiments, use of underfill (e.g. silicone or epoxy) applied through coating, injection, molding, or other suitable application technique can reduce risk of unwanted electrical interconnect, while also providing at least some environmental protection.

Electrically conductive structures can be connected to suitable electric power and drive circuitry directly or through additional printed circuit board or other LED module systems. This power and drive circuitry can be provided by connection of the bottom redistribution layer 148 to the optional CMOS die and support 104. In some embodiments, thickness (Z-height) of the combined substrate 130 bottom redistribution layer 148 and contact pads on the CMOS and support 104 is selected to be less than 25 microns. In other embodiments, thickness of the combined substrate 130 bottom redistribution layer 148 and contact pads on the CMOS and support 104 is selected to be between 5 and 25 microns.

In some embodiments, a thermal conductor (e.g. a copper or other metal slug) can be attached to the bottom of the silicon substrate 130. In other embodiments, an optional printed circuit board with contact pads and electrical traces connecting to CMOS die or control circuitry placed beside or near the multiple pixel assembly 102 can be used.

In some embodiments, microlenses or other primary or secondary optical elements (including reflectors, scattering elements, or absorbers) may be attached or positioned with respect to each LED pixel and associated phosphor. In other embodiments, a primary optic can be positioned over the entire array of LED, and directly attached or mounted at a distance from the LED in suitable packaging. Protective layers, transparent layers, thermal layers, or other packaging structures can be used as needed for specific applications.

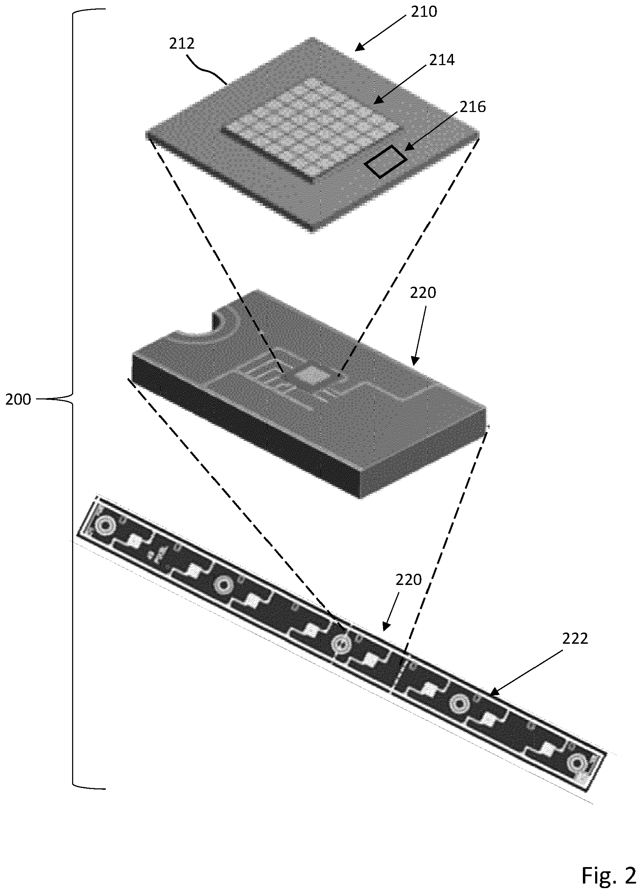

FIG. 2 illustrates a system 200 including a multiple pixel assembly 210 assembled on a substrate 212, which can be inorganic or organic. Phosphors 214 are centered on the substrate 212, which includes a surrounding area capable of supporting CMOS die, control circuitry, or sensors 216. For example, in one embodiment sensors 216 can include one or more light, color, acceleration, or temperature sensors to actively monitor and control operation of the multiple pixel assembly 210. As illustrated, in one embodiment the multiple pixel assembly 210 can be mounted on a flexible printed circuit board 220. This printed circuit board 220 can further include multiple mounting positions 222 for addition pixel assemblies 210.

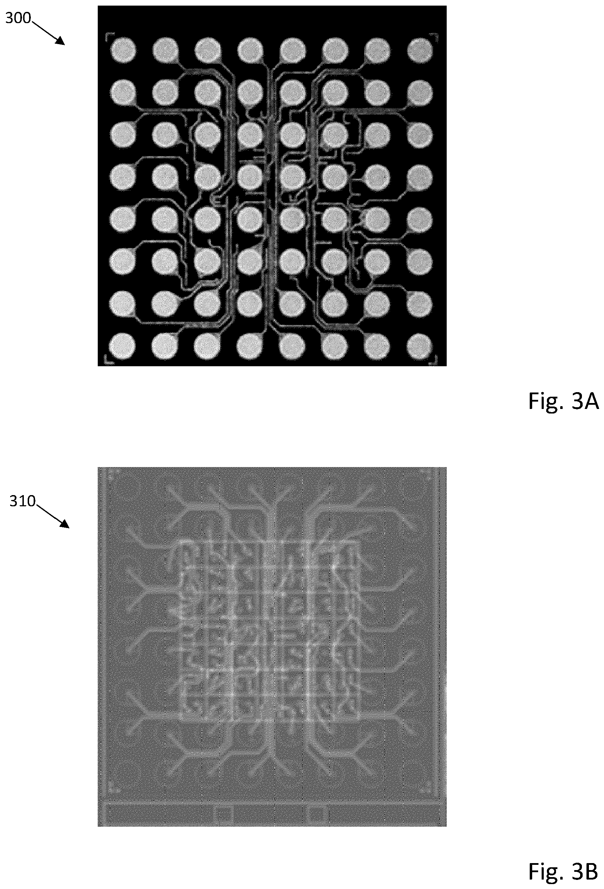

FIG. 3A and 3B illustrate respectively bottom connections and internal connections for a through silicon via substrate. Using through silicon vias and internal redistribution layers, a complex connection scheme between the front and the back can be supported. Illustrated in FIG. 3A is a bottom redistribution layer 300 with traces connecting to copper emplaced in a through silicon via. FIG. 3B illustrates connectivity 310 with a TSV substrate.

The various described embodiments supports light emitting pixel arrays (i.e. addressable LED assemblies) that may support applications that benefit from fine-grained intensity, spatial, and temporal control of light distribution. This may include, but is not limited to, precise spatial patterning of emitted light from pixel blocks or individual pixels. Depending on the application, emitted light may be spectrally distinct, adaptive over time, and/or environmentally responsive. The light emitting pixel arrays may provide pre-programmed light distribution in various intensity, spatial, or temporal patterns. The emitted light may be based at least in part on received sensor data and may be used for optical wireless communications. Associated optics may be distinct at a pixel, pixel block, or device level. An example light emitting pixel array may include a device having a commonly controlled central block of high intensity pixels with an associated common optic, whereas edge pixels may have individual optics. Common applications supported by light emitting pixel arrays include camera flashes, automotive headlights, architectural and area illumination, street lighting, and informational displays.

A light emitting pixel array may be well suited for camera flash applications for mobile devices. Typically, an intense brief flash of light from a high intensity LED is used to support image capture. Unfortunately, with conventional LED flashes, much of the light is wasted on illumination of areas that are already well lit or do not otherwise need to be illuminated. Use of a light emitting pixel array may provide controlled illumination of portions of a scene for a determined amount of time. This may allow the camera flash to, for example, illuminate only those areas imaged during rolling shutter capture, provide even lighting that minimizes signal to noise ratios across a captured image and minimizes shadows on or across a person or target subject, and/or provide high contrast lighting that accentuates shadows. If pixels of the light emitting pixel array are spectrally distinct, color temperature of the flash lighting may be dynamically adjusted to provide wanted color tones or warmth.

Automotive headlights that actively illuminate only selected sections of a roadway are also supported by light emitting pixel arrays. Using infrared cameras as sensors, light emitting pixel arrays activate only those pixels needed to illuminate the roadway while deactivating pixels that may dazzle pedestrians or drivers of oncoming vehicles. In addition, off-road pedestrians, animals, or signs may be selectively illuminated to improve driver environmental awareness. If pixels of the light emitting pixel array are spectrally distinct, the color temperature of the light may be adjusted according to respective daylight, twilight, or night conditions. Some pixels may be used for optical wireless vehicle to vehicle communication.

Architectural and area illumination may also benefit from light emitting pixel arrays. Light emitting pixel arrays may be used to selectively and adaptively illuminate buildings or areas for improved visual display or to reduce lighting costs. In addition, light emitting pixel arrays may be used to project media facades for decorative motion or video effects. In conjunction with tracking sensors and/or cameras, selective illumination of areas around pedestrians may be possible. Spectrally distinct pixels may be used to adjust the color temperature of lighting, as well as support wavelength specific horticultural illumination.

Street lighting is an important application that may greatly benefit from use of light emitting pixel arrays. A single type of light emitting array may be used to mimic various street light types, allowing, for example, switching between a Type I linear street light and a Type IV semicircular street light by appropriate activation or deactivation of selected pixels. In addition, street lighting costs may be lowered by adjusting light beam intensity or distribution according to environmental conditions or time of use. For example, light intensity and area of distribution may be reduced when pedestrians are not present. If pixels of the light emitting pixel array are spectrally distinct, the color temperature of the light may be adjusted according to respective daylight, twilight, or night conditions.

Light emitting arrays are also well suited for supporting applications requiring direct or projected displays. For example, warning, emergency, or informational signs may all be displayed or projected using light emitting arrays. This allows, for example, color changing or flashing exit signs to be projected. If a light emitting array is composed of a large number of pixels, textual or numerical information may be presented. Directional arrows or similar indicators may also be provided.

Having described the invention in detail, those skilled in the art will appreciate that, given the present disclosure, modifications may be made to the invention without departing from the spirit of the inventive concept described herein. Therefore, it is not intended that the scope of the invention be limited to the specific embodiments illustrated and described.

## Claims

1. A packaging structure for a light emitter pixel array, comprising:
a plurality of pixels, with at least some pixels laterally separated from each other with a pixel light confinement structure; and
an inorganic substrate having a top redistribution layer attached to the plurality of pixels and wherein at least one through silicon via containing an electrical conductor is defined to pass through the inorganic substrate and support an electrical connection with the top redistribution layer.

2. The packaging structure for a light emitter pixel array of claim 1, wherein top redistribution layer is attached to each pixel using a copper post.

3. The packaging structure for a light emitter pixel array of claim 1, wherein the inorganic substrate further comprises a bottom redistribution layer attached to the least one through silicon via containing an electrical conductor.

4. The packaging structure for a light emitter pixel array of claim 1, wherein the light confinement structure further comprises phosphor material at least partially surrounded by a reflective side coating.

5. The packaging structure for a light emitter pixel array of claim 1, wherein the light confinement structure further comprises a diffusing layer aligned with phosphor material

6. The packaging structure for a light emitter pixel array of claim 1, wherein total Z-height of the packaging structure is less than 300 microns.

7. The packaging structure for a light emitter pixel array of claim 1, wherein the plurality of pixels includes at least nine pixels.

8. The packaging structure for a light emitter pixel array of claim 1, wherein the plurality of pixels are formed from a segmented GaN layer.

9. The packaging structure for a light emitter pixel array of claim 1, wherein the plurality of pixels are formed from a segmented GaN layer with pixels separated by infilled trenches.

10. The packaging structure for a light emitter pixel array of claim 1, further comprising a CMOS die attached to the bottom redistribution layer of the inorganic substrate.

11. The packaging structure for a light emitter pixel array of claim 1, further comprising underfill between a segmented GaN layer and the inorganic substrate.

12. The packaging structure for a light emitter pixel array of claim 1, further comprising circuitry formed on the inorganic substrate.

13. The packaging structure for a light emitter pixel array of claim 1, further comprising at least one sensor attached to the inorganic substrate.

14. The packaging structure for a light emitter pixel array of claim 1, further comprising at least one sensor temperature sensor attached to the inorganic substrate.
